# EUROPEAN PATENT APPLICATION

(11) **EP 4 801 220 A1**
(43) Date of publication of application: **02.09.2026**
(21) Application number: 25195483.0
(22) Date of filing: 12.08.2025
(51) Int. Cl.: H10B 43/27, H10D 64/01, H10D 30/69, H10D 30/01

(54) **THREE-DIMNESIONAL MEMORY DEVICE AND METHOD OF MANUFACTURING THE SAME**

(30) Priority: 27.02.2025 KR 20250025488; 22.04.2025 KR 20250052456
(71) Applicant: Korea Advanced Institute of Science and Technology, Daejeon 34141 (KR)
(72) Inventor: Cho, Byung Jin, 34141 Daejeon (KR); Park, Jeong-ik, 34141 Daejeon (KR); Park, YoungKeun, 34141 Daejeon (KR); Im, Sung Gap, 34141 Daejeon (KR)
(74) Representative: Kador & Partner Part mbB

(57) **Abstract**

The present disclosure relates to a three-dimensional memory device and a method of manufacturing the same. The three-dimensional memory device includes a substrate, a capping layer, a fluorine-doped layer, a channel layer, a memory layer, and a gate electrode layer. The capping layer extends on the substrate in a vertical direction. The fluorine-doped layer surrounds side surfaces of the capping layer, extends in the vertical direction, and includes a fluorine-containing polymer. The channel layer surrounds side surfaces of the fluorine-doped layer, extends in the vertical direction, and includes polycrystalline silicon in which fluorine is diffused. The memory layer surrounds side surfaces of the channel layer and extends in the vertical direction. The gate electrode layer surrounds side surfaces of the memory layer.

## Description

### CROSS-REFERENCE TO RELATED APPLICATIONS

This application claims priority to and benefits of Korean Patent Application Nos. 10-2025-0025488 and 10-2025-0052456 under 35 U.S.C § 119, filed on February 27, 2025, and April 22, 2025, respectively, in the Korean Intellectual Property Office, the contents of which are incorporated herein in its entirety by reference.

### BACKGROUND

### 1. Technical Field

The present disclosure relates to memory semiconductors, and more particularly, to a three-dimensional memory device and a method of manufacturing the same.

### 2. Description of the Related Art

The following description of related art is provided for the purpose of understanding the context of the present disclosure and is not to be considered as an admission of prior art.

Memory semiconductors can be classified into volatile memory and non-volatile memory. Volatile memory, such as dynamic random access memory (DRAM) and static random access memory (SRAM), offers fast read and write speeds but loses stored data when power is removed. In contrast, non-volatile memory retains data even when power is interrupted. A representative example of non-volatile memory is flash memory, which is widely used as a storage medium in electronic devices such as computers, smartphones, and digital cameras.

With the advancement of artificial intelligence technologies, the emergence of the Internet of Things (IoT), autonomous driving, and smart systems (e.g., smart homes, farms, and factories), the amount of data to be processed has increased dramatically. To address these trends, flash memory requires increased storage capacity and higher integration density. In response, flash memory devices employing three-dimensional (3D) arrangements of memory cells have attracted significant attention. 3D memory devices offer advantages such as high integration density and greater storage capacity per unit area. However, as the degree of integration in the 3D arrangement increases, the electrical characteristics and memory performance may degrade.

### SUMMARY

In one aspect, the present disclosure provides a three-dimensional (3D) memory device that improves electrical characteristics and memory performance under high integration density of memory cells.

The present disclosure also provides a method of manufacturing a three-dimensional memory device that enables uniform diffusion of fluorine throughout a channel layer while reducing damage to the channel layer, thereby enhancing the performance of the three-dimensional memory device.

In one embodiment of the disclosure, the three-dimensional memory device includes a substrate, a capping layer, a fluorine-doped layer, a channel layer, a memory layer, and a gate electrode layer. The capping layer extends on the substrate in a vertical direction away from the substrate. The fluorine-doped layer surrounds side surfaces of the capping layer, extends in the vertical direction, and includes a fluorine-containing polymer. The channel layer surrounds side surfaces of the fluorine-doped layer, extends in the vertical direction, and includes polycrystalline silicon in which fluorine is diffused. The memory layer surrounds side surfaces of the channel layer, and the gate electrode layer surrounds side surfaces of the memory layer.

In one example, the fluorine-containing polymer may include at least one polymer selected from the group consisting of PFDA (3,3,4,4,5,5,6,6,7,7,8,8,9,9,10,10,10-heptadecafluorodecyl acrylate), PFDMA (3,3,4,4,5,5,6,6,7,7,8,8,9,9,10,10,10-heptadecafluorodecyl methacrylate), C6FA (3,3,4,4,5,5,6,6,7,7,8,8,8-tridecafluorooctyl acrylate), and C4FA (3,3,4,4,5,5,6,6,6-nonafluorohexyl acrylate).

In one example, the fluorine-doped layer may be in contact with an inner surface of the channel layer and may cover the entire inner surface of the channel layer.

In one example, the capping layer may include aluminum oxide.

In one example, the doping concentration of fluorine in the channel layer may be higher than the doping concentration of fluorine in the capping layer.

In one example, an outer surface of the channel layer may be in contact with the memory layer and may include diffused fluorine.

In one example, the memory layer may include a tunnel layer in contact with the channel layer and surrounding a side surface of the channel layer, a charge trapping layer surrounding a side surface of the tunnel layer, and a blocking layer surrounding a side surface of the charge trapping layer.

In one example, the fluorine-doped layer may be positioned opposite the gate electrode layer with the channel layer interposed therebetween.

In one embodiment, a method of manufacturing a three-dimensional memory device may include: forming a stacked structure on a substrate; forming a channel hole penetrating the stacked structure in a vertical direction; forming a memory layer on an inner surface of the stacked structure defined by the channel hole; forming a channel layer on an inner surface of the memory layer; forming a fluorine-doped layer comprising a fluorine-containing polymer on an inner surface of the channel layer; forming a capping layer on an inner surface of the fluorine-doped layer; and diffusing fluorine from the fluorine-doped layer into the channel layer through a thermal treatment process.

In one example, the step of forming the fluorine-doped layer may include: injecting an initiator and a fluorine-containing monomer in a gaseous state onto the stacked structure; heating the initiator to generate radicals; adsorbing the monomer and the radicals onto a surface of the channel layer; and forming a thin film comprising a fluorine-containing polymer through polymerization initiated by the radicals.

In one example, the monomer may include at least one selected from the group consisting of PFDA (3,3,4,4,5,5,6,6,7,7,8,8,9,9,10,10,10-heptadecafluorodecyl acrylate), PFDMA (3,3,4,4,5,5,6,6,7,7,8,8,9,9,10,10,10-heptadecafluorodecyl methacrylate), C6FA (3,3,4,4,5,5,6,6,7,7,8,8,8-tridecafluorooctyl acrylate), and C4FA (3,3,4,4,5,5,6,6,6-nonafluorohexyl acrylate). The fluorine-containing polymer may include at least one selected from the group consisting of pPFDA (poly-PFDA), pPFDMA (poly-PFDMA), pC6FA (poly-C6FA), and pC4FA (poly-C4FA).

In one example, the initiator may comprise di-tert-butyl peroxide (DTBP).

In one example, the step of generating radicals may include decomposing the initiator into radicals using a heated filament disposed apart on the stacked structure.

In one example, the temperature of the substrate from heating in the step of generating radicals may be lower than the temperature of the substrate from thermal treatment in the step of diffusing fluorine.

In one example, the method may further comprise removing the fluorine-doped layer and the capping layer after diffusing fluorine.

In one example, the method may further comprise filling a filler into a space previously occupied by the removed fluorine-doped layer and capping layer.

In one example, the capping layer may include aluminum oxide.

In one example, in the step of diffusing fluorine, diffusion of fluorine in a direction away from the channel layer may be suppressed by the capping layer.

In one example, the step of diffusing fluorine, the fluorine may diffuse to an outer surface of the channel layer.

In one example, the step of forming the memory layer may include: forming a blocking layer on the inner surface of the stacked structure; forming a charge trapping layer on an inner surface of the blocking layer; and forming a tunnel layer on an inner surface of the charge trapping layer.

According to an embodiment of the present disclosure, a three-dimensional memory device can improve the electrical characteristics and memory performance of highly integrated memory cells by diffusing fluorine into a channel layer using a fluorine-doped layer and a capping layer.

In addition, according to an embodiment of the present disclosure, the three-dimensional memory device and the method of manufacturing the same employ initiated chemical vapor deposition (iCVD) to form the fluorine-doped layer, thereby enabling uniform diffusion of fluorine throughout the channel layer while minimizing damage to the channel layer.

### BRIEF DESCRIPTION OF THE DRAWINGS

These and/or other features will become apparent and more readily appreciated from the following description of the embodiments, taken in conjunction with the accompanying drawings.
FIG. 1 is a perspective view of a three-dimensional memory device according to an embodiment of the present disclosure.
FIG. 2 is a circuit diagram of the three-dimensional memory device of FIG. 1.
FIG. 3 is a diagram schematically illustrating a pillar of the three-dimensional memory device of FIG. 1.
FIG. 4 is a cross-sectional view illustrating a process of diffusing fluorine into the pillar of FIG. 3.
FIG. 5 is a diagram schematically illustrating another example of a pillar of the three-dimensional memory device of FIG. 1.
FIG. 6 is an exemplary flowchart illustrating a method of manufacturing the three-dimensional memory device of FIG. 1.
FIGS. 7A to 7E are cross-sectional views illustrating steps of manufacturing the three-dimensional memory device of FIG. 1.
FIG. 8 is a flowchart detailing the step of forming a doping control layer in the method of FIG. 6.
FIG. 9 is a schematic diagram illustrating the step of forming a doping control layer in the method of FIG. 6.
FIGS. 10 to 15 are graphs illustrating improvements in electrical characteristics of the three-dimensional memory device according to an embodiment of the present disclosure.
FIGS. 16 to 21 are graphs illustrating improvements in memory characteristics of the three-dimensional memory device according to an embodiment of the present disclosure.

### DETAILED DESCRIPTION

Hereinafter, certain embodiments of the present disclosure will be described in more detail with reference to the accompanying drawings. In the drawings, the proportions and dimensions of components may be exaggerated for clarity and ease of explanation.

Any expressions such as "comprise" or "include" are intended to specify the presence of features, integers, steps, operations, elements, components, or combinations thereof stated in the specification, and shall not be construed to preclude any possibility of presence or addition of one or more other features, integers, steps, operations, elements, components, or combinations thereof.

Furthermore, when a component is described as being "on" another component, it may be located above or below the other component and does not necessarily imply being positioned on the upper side in the direction of gravity.

When a component is described as being "connected" or "coupled" to another component, it may be directly connected or coupled to the other component or indirectly connected or coupled via another component.

Terms such as "first" and "second" may be used when referring to components, but these terms are intended only for distinguishing one component from another and do not imply any limitation on the nature, order, or sequence of the components.

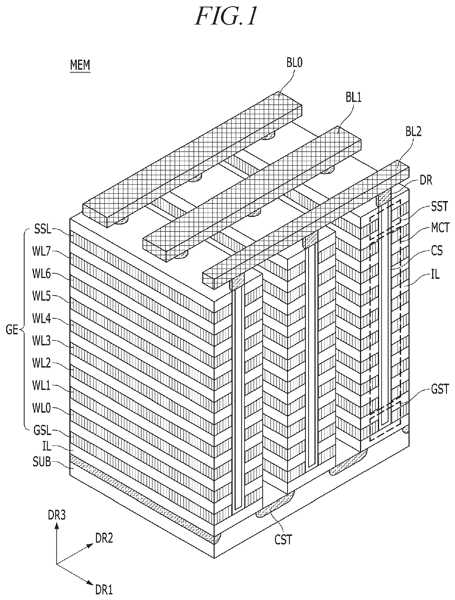

FIG. 1 is a perspective view of a three-dimensional (3D) memory device according to an embodiment of the present disclosure. For the purpose of describing the 3D memory device according to an embodiment of the present disclosure, mutually orthogonal first to third directions DR1-DR3 are defined. The 3D memory device may include a vertical NAND (V-NAND) flash memory but is not limited thereto and may be applied to various memory devices having a three-dimensional arrangement of memory cells. Referring to FIG. 1, the 3D memory device MEM includes a substrate SUB, a gate electrode layer GE, an insulating layer IL, a pillar CS, and an upper conductive pattern.

The substrate SUB may be a semiconductor substrate, for example, a p-type substrate. The substrate SUB has a plane defined by the first direction DR1 and the second direction DR2. In an example, as illustrated, a common source line CSL may be provided in the substrate SUB. The common source line CSL may extend in the first direction DR1 and is electrically connected to a channel formed in the pillar CS.

The gate electrode layer GE and the insulating layer IL are disposed on the substrate SUB. The gate electrode layer GE and the insulating layer IL may be repeatedly stacked in the third direction DR3, thereby forming a stacked structure. The gate electrode layer GE and the insulating layer IL surround the pillar CS. In one example, as opposed to the illustrated embodiment, a memory layer in which data is stored and the insulating layer IL may be stacked, and the gate electrode layer may surround the stacked structure. Such a stacked structure may be formed by alternately stacking target layers (e.g., the gate electrode layer GE and the insulating layer IL). Alternatively, the stacked structure may be formed by repeatedly stacking a first target layer and a sacrificial layer, forming the pillars CS to penetrate the stacked layers, removing the sacrificial layers, and then forming second target layers in the regions from which the sacrificial layers have been removed.

The gate electrode layer GE includes a conductive material and is arranged in the third direction DR3. The gate electrode layer GE surrounds at least a portion of a side surface of the pillar CS. The gate electrode layer GE includes a string selection line SSL, word lines WL0-WL7, and a ground selection line GSL. The string selection line SSL may form a string selection transistor SST in conjunction with the pillar CS. The word lines WL0-WL7 may form memory cell transistors MCT in conjunction with the pillar CS. The ground selection line GSL may form a ground selection transistor GST in conjunction with the pillar CS. The string selection line SSL, the word lines WL0-WL7, and the ground selection line GSL may electrically connect the string selection transistor SST, the memory cell transistors MCT, and the ground selection transistor GST, respectively, to a driving circuit (not shown).

The insulating layer IL includes an insulating material and is arranged in the third direction DR3. The insulating layer IL surrounds at least a portion of the side surface of the pillar CS and may include an oxide. The insulating layer IL electrically isolates the string selection line SSL, the word lines WL0-WL7, and the ground selection line GSL from one another, and may also electrically isolate the string selection transistor SST, the memory cell transistors MCT, and the ground selection transistor GST from each other.

The pillar CS penetrates the insulating layer IL and the gate electrode layer GE to extend in the third direction DR3. The pillar CS is two-dimensionally arranged with respect to the first direction DR1 and the second direction DR2. The pillar CS may be in contact with the substrate SUB and electrically connected to the common source line CSL. The pillar CS forms a channel between the upper conductive pattern and the common source line CSL. A detailed description of the pillar CS will be provided later.

The upper conductive pattern includes a conductive material and is disposed on the stacked structure STS and the pillar CS. The upper conductive pattern includes a contact pattern DR and bit lines BL0-BL2. The contact pattern DR may electrically connect the bit lines BL0-BL2 to the pillar CS. The bit lines BL0-BL2 may extend in the second direction DR2 and may be arranged in the first direction DR1.

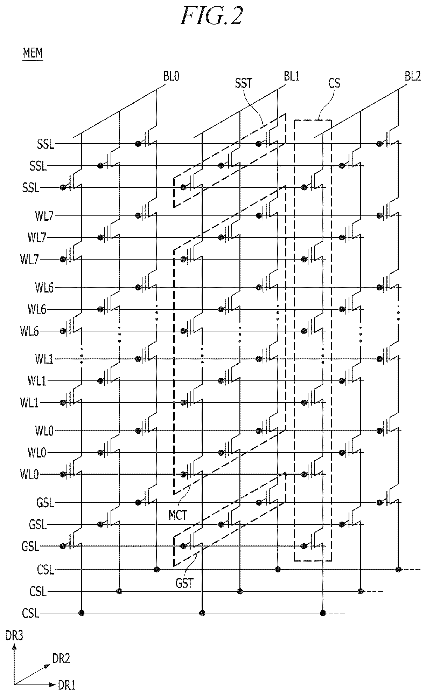

FIG. 2 is a circuit diagram of the 3D memory device of FIG. 1. Referring to FIG. 2, the 3D memory device MEM includes a common source line CSL, bit lines BL0-BL2, a string selection line SSL, word lines WL0-WL7, a ground selection line GSL, and a cell string CS. The cell string CS includes a string selection transistor SST, memory cell transistors MCT, and a ground selection transistor GST.

The bit lines BL0-BL2 may be arranged in the first direction DR1. A plurality of cell strings CS may be connected in parallel to each of the bit lines BL0-BL2. The plurality of cell strings CS may be commonly connected to the common source line CSL. The plurality of cell strings CS may be disposed between the plurality of bit lines BL0-BL2 and a single common source line CSL. The common source line CSL may be provided in plurality, and the plurality of common source lines CSL may be arranged in the second direction DR2. However, the embodiment is not limited thereto, and there may be a single common source line CSL. The same voltage may be applied to the common source line CSL, but this is not limiting.

The cell string CS may be constituted with a ground selection transistor GST connected to the common source line CSL, a string selection transistor SST connected to one of the bit lines BL0-BL2, and memory cell transistors MCT disposed between the ground selection transistor GST and the string selection transistor SST. One ground selection transistor GST, a plurality of memory cell transistors MCT, and one string selection transistor SST may be connected in series. The common source line CSL may be commonly connected to the sources of the plurality of ground selection transistors GST.

The ground selection line GSL, the word lines WL0-WL7, and the string selection line SSL may serve as the gate electrodes of the ground selection transistor GST, the memory cell transistors MCT, and the string selection transistor SST, respectively. The ground selection transistor GST may connect the cell string CS to the common source line CSL based on a selection signal received from the connected ground selection line GSL. The string selection transistor SST may connect the cell string CS to one of the bit lines BL0-BL2 based on a selection signal received from the connected string selection line SSL.

Moreover, each of the memory cell transistors MCT may be selected based on a selection signal received from the word lines WL0-WL7 to enable a read or write operation. The memory cell transistors MCT include memory elements for storing data, such as by trapping charge. The memory elements may perform a write operation by storing data through charge trapping, a read operation by controlling current flowing in the channel based on the trapped charge, and an erase operation by releasing the trapped charge to delete stored data.

To meet the demand for increased integration density of the memory cell transistors MCT, the number of memory cell transistors MCT arranged in the third direction DR3 is increased, and the spacing between the memory cell transistors MCT is reduced. That is, the height of the pillar CS shown in FIG. 1 increases, and the height of the word lines WL0-WL7 decreases. The short channel effects associated with the shortened gate length may be mitigated by reducing the cell diameter to increase gate controllability. In other words, the diameter of the pillar CS may decrease, and the channel may become thinner.

An increase in the height of the pillar CS increases the channel resistance, thereby reducing the cell string current. The thinner channel reduces the grain size, which similarly reduces the cell string current. In addition, the increase in grain boundaries in the channel raises the threshold voltage of the transistors. Problems arising from such changes in electrical characteristics may be addressed by passivating interface trap sites caused by dangling bonds at the interface between the channel and the gate insulating layer. The present disclosure may perform fluorine passivation using initiated chemical vapor deposition (iCVD), details of which will be described later.

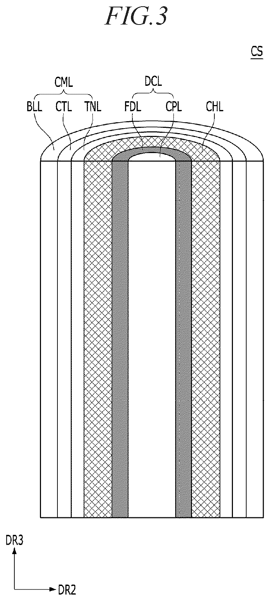

FIG. 3 is a diagram schematically illustrating the pillar CS shown in FIG. 1. Referring to FIG. 3, the pillar CS includes a memory layer CML, a channel layer CHL, and a doping control layer DCL. The memory layer CML, the channel layer CHL, and the doping control layer DCL extend in the third direction DR3. The pillar CS is surrounded by a gate electrode layer GE.

The memory layer CML corresponds to the memory element described in FIG. 2 and may store data by trapping charge. The memory layer CML is disposed between the gate electrode layers GE and the channel layer CHL and surrounds a side surface of the channel layer CHL. A single pillar CS may be constituted with a single memory layer CML; however, the embodiment is not limited thereto, and the memory layer CML may be divided into portions corresponding to the number of memory cell transistors MCT. In such a case, each memory layer CML may surround a portion of the channel layer CHL corresponding to a respective memory cell transistor MCT. The memory layer CML may include a tunnel layer TNL, a charge trapping layer CTL, and a blocking layer BLL. However, the memory layer CML is not limited thereto, and any other layer capable of storing data by trapping charge may be referred to as a memory layer CML.

The blocking layer BLL is disposed between the gate electrode layer GE and the charge trapping layer CTL and surrounds a side surface of the charge trapping layer CTL. Unlike the illustration, the blocking layer BLL may be divided into portions corresponding to the number of memory cell transistors MCT and may further cover upper and lower portions of the divided charge trapping layers CTL. The blocking layer BLL is configured to prevent charge trapped in the charge trapping layer CTL from moving to the gate electrode layer GE. The blocking layer BLL may include an insulating material such as aluminum oxide (Al₂O₃) and may have a higher bandgap energy than the charge trapping layer CTL. In one example, the blocking layer BLL may be formed by, but not limited to, atomic layer deposition (ALD).

The charge trapping layer CTL is disposed between the blocking layer BLL and the tunnel layer TNL and surrounds a side surface of the tunnel layer TNL. Unlike the illustration, the charge trapping layer CTL may be divided into portions corresponding to the number of memory cell transistors MCT and may further cover upper and lower portions of the divided tunnel layers TNL. The charge trapping layer CTL is configured to trap charge injected from the channel layer CHL based on a gate voltage applied from the gate electrode layer GE. In one example, the charge trapping layer CTL may be silicon nitride (Si₃N₄) formed by atomic layer deposition.

The tunnel layer TNL is disposed between the charge trapping layer CTL and the channel layer CHL and surrounds a side surface of the channel layer CHL. Unlike the illustration, the tunnel layer TNL may be divided into portions corresponding to the number of memory cell transistors MCT. For example, insulating layers IS of the stacked structure STS may be used for forming the divided tunnel layers TNL. In one example, the tunnel layer TNL may include, but not limited to, an oxide such as silicon oxide and may be formed by atomic layer deposition.

The tunnel layer TNL is configured to control movement of charge between the charge trapping layer CTL and the channel layer CHL based on the gate voltage. When the difference in bandgap energy between the charge trapping layer CTL and the channel layer CHL is large under the gate voltage, the band slope of the tunnel layer TNL changes, and charge may move between the charge trapping layer CTL and the channel layer CHL via tunneling. Otherwise, the tunnel layer TNL may act as an energy barrier.

The channel layer CHL is disposed between the memory layer CML and the doping control layer DCL and surrounds a side surface of the doping control layer DCL. The channel layer CHL extends in the third direction DR3 and forms a channel through which charge moves between the bit lines BL0-BL2 and the common source line CSL. Charge present in the channel layer CHL may be injected into the memory layer CML based on a gate voltage and may be released from the memory layer CML back into the channel layer CHL based on the gate voltage. In one example, the channel layer CHL may include, but not limited to, polycrystalline silicon.

The channel layer CHL includes fluorine diffused from the doping control layer DCL. As described above, with increasing integration density, the thickness of the channel layer CHL in the second direction DR2 decreases, while the length thereof in the third direction DR3 increases. Accordingly, the cell string current decreases, and the threshold voltage of the transistors increases. To this end, the entire inner surface of the channel layer CHL may be in contact with the doping control layer DCL and doped with fluorine diffused from the doping control layer DCL. The diffused fluorine may reach the outer surface of the channel layer CHL in contact with the memory layer CML, thereby passivating interface trap sites.

The doping control layer DCL may diffuse fluorine into the channel layer CHL to improve electrical characteristics associated with increased pillar height, reduced pillar diameter, and reduced channel layer thickness. For this purpose, the doping control layer DCL may include a fluorine-doped layer FDL and a capping layer CPL and may be in contact with the inner surface of the channel layer CHL.

The fluorine-doped layer FDL is disposed between the channel layer CHL and the capping layer CPL, is in contact with the inner surface of the channel layer CHL, and surrounds a side surface of the capping layer CPL. The fluorine-doped layer FDL includes a fluorine-containing polymer. Since fluorine has a higher bonding energy with silicon compared to hydrogen, higher stability and reliability can be ensured against external stress than hydrogen passivation. Furthermore, because fluorine has a smaller atomic radius and higher electronegativity than hydrogen, it can provide a higher trap passivation efficiency.

The fluorine-doped layer FDL may be formed on the channel layer CHL using initiated chemical vapor deposition (iCVD). To passivate the channel layer CHL with fluorine, plasma treatment or ion implantation may be considered. However, plasma treatment makes it difficult to form a uniform plasma within a channel hole, and fluorine-based plasmas (e.g., SF₆, CF₄, C₂F₆) may damage the surface of the channel layer CHL due to low selectivity of a polycrystalline silicon channel. In the case of ion implantation, shadowing effects inside the channel hole may prevent ions from reaching certain regions, and ion bombardment during the injection of fluorine ions may damage the surface of the channel layer CHL.

The iCVD process is an all-dry process that has advantages such as the absence of surface tension during formation of the fluorine-doped layer FDL, uniform deposition by isotropic diffusion of monomers and radicals, and reduced cooling time due to low-temperature processing. As a result, the fluorine-doped layer FDL may be uniformly formed over the entire inner surface of the channel layer CHL, and damage to the channel layer CHL may be minimized.

The fluorine-doped layer FDL may be formed by injecting an initiator and a fluorine-containing monomer, heating the initiator to generate radicals, adsorbing the monomer and radicals onto the surface of the channel layer CHL, and polymerizing to form a fluorine-containing polymer. Accordingly, the fluorine-doped layer FDL may include a fluorine-containing polymer, such as poly-perfluorodecanoic acid (pPFDA), as an example. After forming the fluorine-doped layer FDL, fluorine may be diffused from the fluorine-doped layer FDL into the channel layer CHL by thermal treatment.

The capping layer CPL is disposed on an inner surface of the fluorine-doped layer FDL and may fill the interior of the fluorine-doped layer FDL. The capping layer CPL may be configured to suppress movement of fluorine in a direction away from the channel layer CHL during the diffusion of fluorine into the channel layer CHL. To this end, the capping layer CPL may include an insulating material that blocks fluorine movement, such as aluminum oxide (Al₂O₃). The capping layer CPL may have a higher bandgap energy than the channel layer CHL and may be formed by, but not limited to, atomic layer deposition (ALD).

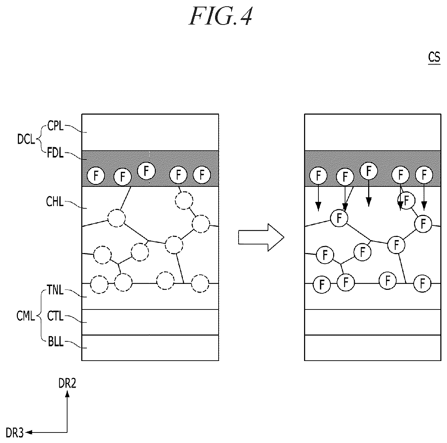

FIG. 4 is a cross-sectional view illustrating a process of diffusing fluorine into the pillar CS shown in FIG. 3. Referring to FIG. 4, the pillar CS includes a memory layer CML, a channel layer CHL, and a doping control layer DCL. The memory layer CML includes a tunnel layer TNL, a charge trapping layer CTL, and a blocking layer BLL. The doping control layer DCL includes a fluorine-doped layer FDL and a capping layer CPL.

The fluorine-doped layer FDL, which includes a fluorine-containing polymer, may diffuse fluorine into the channel layer CHL through a thermal treatment process. In one example, fluorine may be deeply diffused into the channel layer CHL through a drive-in process. The fluorine diffuses into the polycrystalline silicon of the channel layer CHL along grain boundaries. The fluorine passivates trap sites at the grain boundaries, thereby filling defects in the channel layer CHL. The fluorine may diffuse to the outer surface of the channel layer CHL in contact with the tunnel layer TNL. As a result, the electrical characteristics of the channel layer CHL may be improved.

The capping layer CPL may prevent fluorine from outgassing from the fluorine-doped layer FDL in a direction away from the channel layer CHL. The capping layer CPL includes an insulating material that blocks movement of fluorine. The fluorine may not diffuse from the fluorine-doped layer FDL into the capping layer CPL. As a result, the doping concentration of fluorine in the channel layer CHL is higher than the doping concentration of fluorine in the capping layer CPL.

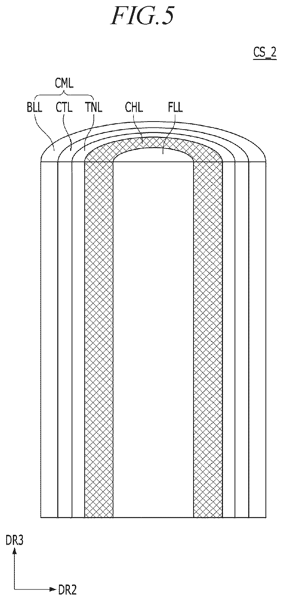

FIG. 5 is a diagram schematically illustrating another example of a pillar of the three-dimensional memory device MEM shown in FIG. 1. Referring to FIG. 5, the pillar CS_2 includes a memory layer CML, a channel layer CHL, and a filler layer FLL. The memory layer CML includes a tunnel layer TNL, a charge trapping layer CTL, and a blocking layer BLL. For convenience of explanation, FIG. 5 will be described in comparison with FIG. 3.

The filler layer FLL may fill the interior of the channel layer CHL. The filler layer FLL may be disposed on the inner surface of the channel layer CHL in place of the doping control layer DCL shown in FIG. 3. After the fluorine diffusion process described with reference to FIGS. 3 and 4, the doping control layer DCL may be removed. The filler layer FLL may then be filled into the space from which the doping control layer DCL was removed. The filler layer FLL may include an insulating material for purposes such as preventing leakage current, for example, silicon oxide.

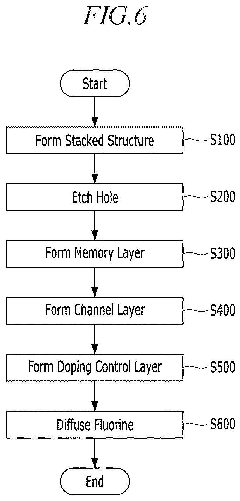

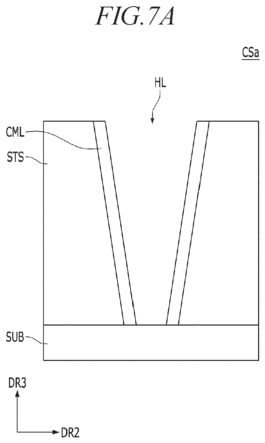

FIG. 6 is an exemplary flowchart illustrating a method of manufacturing the three-dimensional memory device shown in FIG. 1. FIGS. 7A to 7E are cross-sectional views illustrating steps of manufacturing the three-dimensional memory device MEM. It should be understood that each step of the manufacturing method described with reference to FIG. 6 is exemplary. In particular, steps other than S400, S500, and S600, which involve forming the doping control layer DCL on the channel layer CHL and diffusing fluorine, may be performed with variations in order, additions, or omissions. Each step of FIG. 6 will be described with reference to the cross-sectional views of FIGS. 7A to 7E.

Referring to FIG. 7A, in step S100, a stacked structure STS is formed on a substrate SUB. Here, the stacked structure STS may refer to a structure in which gate electrode layers GE and insulating layers IL are repeatedly stacked in the third direction DR3, as described with reference to FIG. 1. However, the disclosure is not limited thereto, and the stacked structure STS may alternatively be a structure in which sacrificial layers are stacked in place of the gate electrode layers GE or insulating layers IL. The sacrificial layers may be removed later, and the gate electrode layers GE or insulating layers IL may be formed in the space from which the sacrificial layers were removed. In one example, the stacked structure STS may be a structure in which oxide insulating layers IL and nitride sacrificial layers are stacked.

In step S200, a channel hole HL is formed to penetrate the stacked structure STS. The channel hole HL extends deeply and narrowly in the third direction DR3. The channel hole HL may be formed by performing etching suitable for a high aspect ratio structure. In one example, the channel hole HL may be formed using a specialized etching process such as deep reactive ion etching (DRIE), although the disclosure is not limited thereto.

In step S300, a memory layer CML is formed. The memory layer CML may be formed within the channel hole HL. The memory layer CML may also be formed on an inner surface of the stacked structure STS. As described above, the memory layer CML may include a blocking layer BLL, a charge trapping layer CTL, and a tunnel layer TNL. However, the disclosure is not limited thereto, and any structure capable of trapping charge to store data may also be referred to as the memory layer CML. The blocking layer BLL, the charge trapping layer CTL, and the tunnel layer TNL may be sequentially formed. Specifically, the blocking layer BLL may be formed on the inner surface of the stacked structure STS, the charge trapping layer CTL may be formed on an inner surface of the blocking layer BLL, and the tunnel layer TNL may be formed on an inner surface of the charge trapping layer CTL. In one example, the memory layer CML may be formed by atomic layer deposition (ALD).

The memory layer CML is not limited to the structure shown in FIG. 7A. For example, the memory layer CML may be divided into portions corresponding to the number of memory cell transistors MCT. In addition, the memory layer CML may be formed not within the channel hole HL but beneath the stacked structure STS. The memory layer CML may be formed in a direction away from the channel hole HL relative to the inner surface of the stacked structure STS. For example, an insulating layer of the stacked structure STS may be used to form the tunnel layer TNL of the memory layer CML. In such a case, the memory layer CML may be generated by further forming the charge trapping layer CTL and the blocking layer BLL on the tunnel layer TNL, and the channel layer CHL may be directly formed on the inner surface of the channel hole HL or the stacked structure STS. Accordingly, step S300 may be performed after step S400, in which the channel layer CHL is formed.

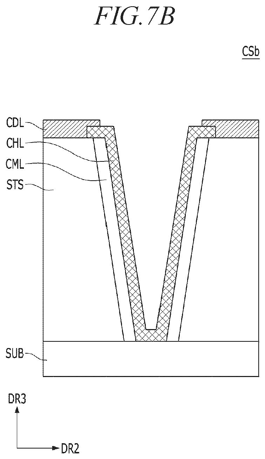

Referring to FIG. 7B, in step S400, a channel layer CHL is formed within the channel hole HL. The channel layer CHL is formed on an inner surface of the memory layer CML. The channel layer CHL may cover the entire side surface of the channel hole HL. In one example, the channel layer CHL may be formed by depositing amorphous silicon at a low temperature within the channel hole HL and crystallizing it into polycrystalline silicon through solid phase crystallization (SPC). In one example, a conductive layer CDL may further be formed on the channel layer CHL. The conductive layer CDL may be a part of the contact pattern DR included in the upper conductive pattern shown in FIG. 1.

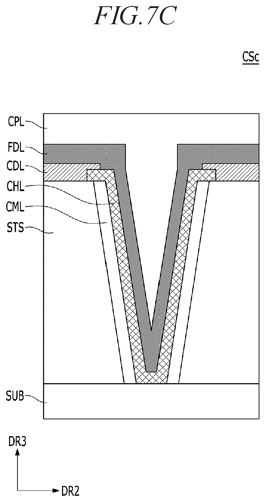

Referring to FIG. 7C, in step S500, a doping control layer DCL is formed on an inner surface of the channel layer CHL. The doping control layer DCL includes a fluorine-doped layer FDL and a capping layer CPL. The fluorine-doped layer FDL is formed on the inner surface of the channel layer CHL. The fluorine-doped layer FDL may be uniformly formed to cover the entire side surface of the channel layer CHL through an iCVD process. The fluorine-doped layer FDL includes a fluorine-containing polymer. The fluorine-doped layer FDL extends along the channel layer CHL in the third direction DR3 and may further extend on a plane perpendicular to the third direction DR3 to cover at least a portion of the stacked structure STS and the conductive layer CDL.

The capping layer CPL is formed on an inner surface of the fluorine-doped layer FDL. The capping layer CPL may be formed to fill the interior of the channel hole HL. The capping layer CPL extends along the fluorine-doped layer FDL in the third direction DR3 and may further extend on a plane perpendicular to the third direction DR3 to cover at least a portion of the fluorine-doped layer FDL. In one example, the capping layer CPL may be formed by atomic layer deposition (ALD).

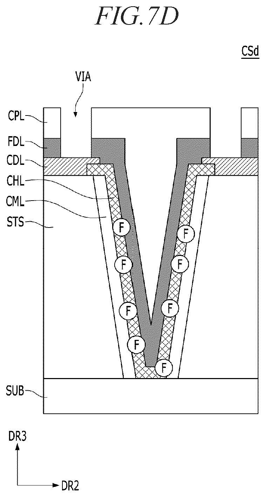

Referring to FIG. 7D, in step S600, fluorine may be diffused from the fluorine-doped layer FDL into the channel layer CHL. Fluorine may be diffused deeply into the channel layer CHL through a drive-in process. Through thermal treatment, the fluorine may diffuse to the outer surface of the channel layer CHL that is in contact with the tunnel layer TNL. Additionally, a via VIA may be formed in the conductive layer CDL. A contact pattern electrically connected to the bit lines BL0-BL2 may further be formed in the via VIA.

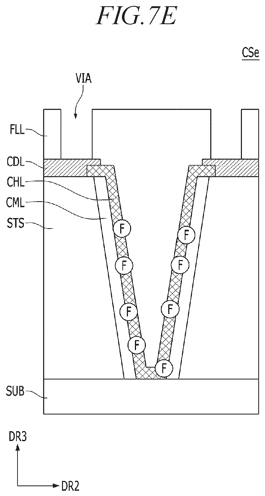

Referring to FIG. 7E, the fluorine-doped layer FDL and the capping layer CPL formed in step S500 are removed, and a filler layer FLL may be filled into the channel hole HL. As described with reference to FIG. 5, the fluorine-doped layer FDL and the capping layer CPL may be removed after fluorine has been diffused into the channel layer CHL. In such a case, the via VIA may be formed after the filler layer FLL has been formed.

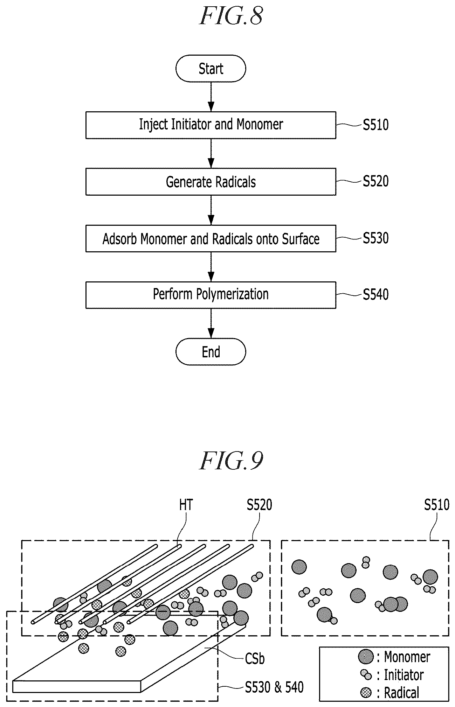

FIG. 8 is a flowchart detailing the step of forming the doping control layer DCL in the method illustrated in FIG. 6. FIG. 9 is a schematic diagram illustrating the step of forming the doping control layer DCL in the method illustrated in FIG. 6. FIGS. 8 and 9 shall be understood to detail the steps of an iCVD process for forming the fluorine-doped layer FDL within the doping control layer DCL. Each step of FIG. 8 will be described with reference to FIG. 9.

In step S510, an initiator and a monomer may be injected so as to reach onto a memory substrate including the stacked structure STS. The initiator and the monomer are injected in a gaseous state. Here, the initiator shall be understood as a molecule for generating radicals. In one example, the initiator may be di-tert-butyl peroxide (DTBP), but the disclosure is not limited thereto, and the initiator may include at least one of various substances capable of generating radicals, such as tert-butyl peroxide (TBPO) or t-butyl peroxybenzoate (TBPOB). The monomer is understood as a raw material for forming a thin film and includes fluorine. In one example, the monomer may be perfluorodecanoic acid (PFDA; 3,3,4,4,5,5,6,6,7,7,8,8,9,9,10,10,10-heptadecafluorodecyl acrylate). However, the disclosure is not limited thereto, and the monomer may include at least one of various fluorine-containing substances, such as perfluorodecyl methacrylate (PFDMA; 3,3,4,4,5,5,6,6,7,7,8,8,9,9,10,10, 10-heptadecafluorodecyl methacrylate), tridecafluorooctyl acrylate (C6FA; 3,3,4,4,5,5,6,6,7,7,8,8,8-tridecafluorooctyl acrylate), or nonafluorohexyl acrylate (C4FA; 3,3,4,4,5,5,6,6,6-nonafluorohexyl acrylate).

In step S520, the initiator is heated to generate radicals. The initiator may be heated by a heating filament HT. In one example, the heating filament HT may be disposed spaced apart from the stacked structure STS on the memory substrate. For example, the heating filament HT may be two-dimensionally arranged in a plane perpendicular to the vertical direction (third direction DR3) so as to heat the entire plane of the memory substrate. The initiator is thermally decomposed into radicals by the heating filament HT.

In step S530, the monomer and the radicals are adsorbed onto the surface of the memory substrate. Specifically, the monomer and the radicals may be adsorbed onto the surface of the channel layer CHL formed within the channel hole HL.

In step S540, a polymerization reaction is initiated by the radicals. The adsorbed radicals initiate the polymerization of the monomer. As a result, polymer chains are formed and grow as a thin film on the surface of the memory MEMb, specifically on the surface of the channel layer CHL. That is, the fluorine-containing monomer undergoes polymerization to form a fluorine-containing polymer. In one example, the fluorine-containing polymer may be pPFDA. However, the disclosure is not limited thereto, and the fluorine-containing polymer may be a product of the polymerization of at least one of the monomers mentioned in step S510, such as pPFDA (poly-PFDA), pPFDMA (poly-PFDMA), pC6FA (poly-C6FA), or pC4FA (poly-C4FA).

When the fluorine-doped layer FDL is formed through steps S510 to S540, the process is performed entirely as a dry process, enabling uniform thin film formation without surface tension. The fluorine-doped layer FDL is deposited uniformly by isotropic diffusion of the monomer and radicals. Furthermore, because the process is carried out at a low temperature, damage to the surface of the memory substrate, including the channel layer CHL, is minimized. As a result, the cooling time and energy required for subsequent steps may be reduced.

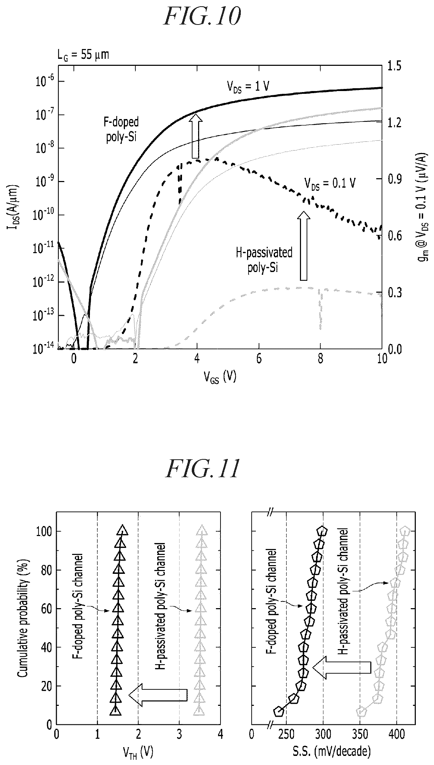

FIGS. 10 to 15 are graphs illustrating improvements in electrical characteristics of the three-dimensional memory device according to an embodiment of the present disclosure. The comparative example is a three-dimensional memory device in which trap sites have been passivated with hydrogen through forming gas annealing.

Referring to FIG. 10, the transfer characteristics (I_{DS}-V_{GS}) of the three-dimensional memory device are shown. The horizontal axis represents the gate-to-source voltage, and the vertical axis represents the cell string current (drain-to-source current) or transconductance (with the drain-to-source voltage set to 0.1 V). The solid line represents the cell string current, while the dashed line represents the transconductance. The arrows indicate changes in characteristics of the device according to the present disclosure compared to the comparative example.

**In** the case of the three-dimensional memory device including a channel in which fluorine has been diffused through an iCVD process, as in the present disclosure, improved transfer characteristics are exhibited compared to hydrogen passivation. Specifically, as shown by the solid line, the on-current is improved, and the threshold voltage has shifted in a negative direction from approximately 3.5 V to approximately 1.5 V Furthermore, the transconductance is improved by about three times.

This improvement in electrical characteristics indicates that fluorine doped into the channel layer CHL has passivated defects and trap sites caused by grain boundaries. Moreover, fluorine, which has higher electronegativity than hydrogen, has more effectively passivated trap sites at grain boundaries. This can be interpreted as resulting from a reduction in deep states, i.e., dangling bonds, near the mid-gap in the energy band gap of the polycrystalline silicon in the channel layer CHL.

Referring to FIG. 11, cumulative distribution functions of the threshold voltage and subthreshold swing are shown. Compared to the comparative example, in the case of the present disclosure, the threshold voltage has shifted in a negative direction from approximately 3.5 V to approximately 1.5 V. In addition, the subthreshold swing is shown to have improved from 389 mV/decade to 278 mV/decade, representing approximately a 30% enhancement. This indicates that fluorine has diffused to the interface between the tunnel layer TNL and the channel layer CHL and that the interface traps have been effectively passivated compared to hydrogen passivation.

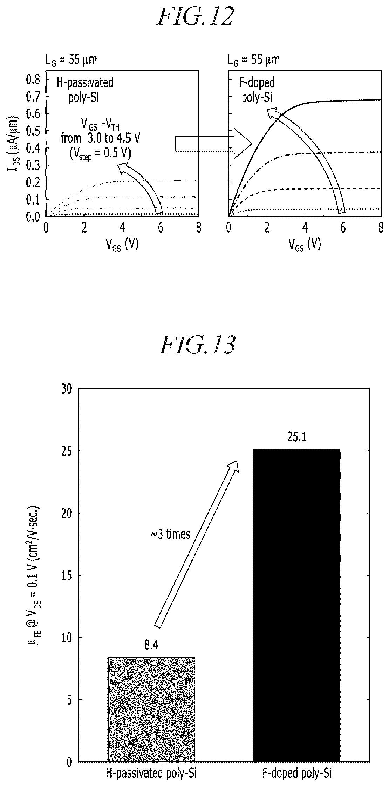

Referring to FIG. 12, the output characteristics (I_{DS}-V_{DS}) of the three-dimensional memory device are shown. The horizontal axis is defined as the drain-to-source voltage, and the vertical axis is defined as the cell string current (drain-to-source current). The output characteristics are directly related to the field-effect mobility, which is an indicator for evaluating the potential to mitigate mobility degradation in the polycrystalline silicon channel. A comparison of the saturated drain-to-source current with respect to the gate voltage (V_{GS}-V_{TH}), in which the threshold voltage is reflected, shows that the present disclosure achieves an approximately 300% improvement over the comparative example.

Referring to FIG. 13, the field-effect mobility of the three-dimensional memory device is shown (with the drain-to-source voltage set to 0.1 V). The field-effect mobility may be extracted from the transconductance mentioned with reference to FIG. 10. In the comparative example, the field-effect mobility is 8.4 cm²/V·sec, whereas in the present disclosure, the field-effect mobility is 25.1 cm²/V·sec. Accordingly, the field-effect mobility is improved by approximately three times compared to the comparative example. The results of FIGS. 12 and 13 indicate that the fluorine doping technique using iCVD has improved channel mobility.

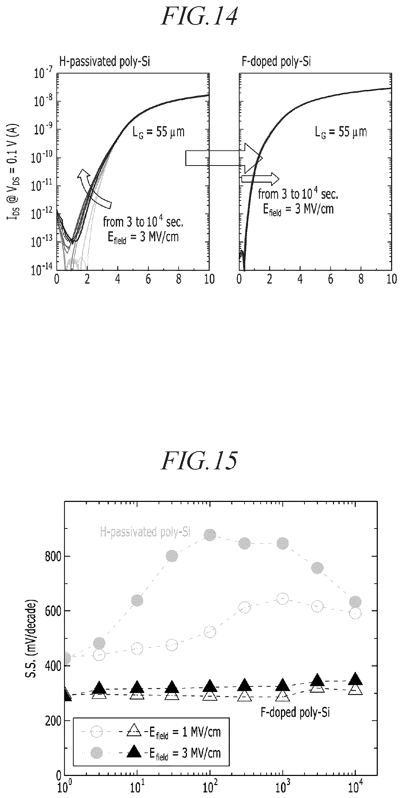

Referring to FIG. 14, the positive bias stress (PBS) characteristics are shown. The horizontal axis is defined as the gate-to-source voltage, and the vertical axis is defined as the cell string current (drain-to-source current) (with the drain-to-source voltage set to 0.1 V). Considering the V-NAND flash memory scheme, in which a relatively high electric field is applied compared to other memory devices, a PBS test is conducted by applying a constant electric field to the gate while observing changes in transfer characteristics. In the comparative example, under a condition where an electric field of 3 MV/cm is applied to the gate, the subthreshold swing characteristics degrade as the stress time increases. In contrast, in the case of the present disclosure, the subthreshold swing characteristics are maintained even after a stress time of 10⁴ seconds.

Referring to FIG. 15, the subthreshold swing is shown as a function of stress time. Under conditions where electric fields of 1 MV/cm and 3 MV/cm are applied to the gate, the comparative example exhibits a region in which the subthreshold swing increases significantly as the stress time increases. In contrast, in the case of the present disclosure, the subthreshold swing characteristics remain stable despite the increase in the stress time.

The results of FIGS. 14 and 15 demonstrate that fluorine diffusion through doping provides superior stability against PBS compared to hydrogen passivation. This outcome can be interpreted as resulting from the fact that fluorine has a stronger bonding energy than hydrogen, thereby suppressing depassivation caused by external electric fields. Accordingly, the present disclosure provides improved stability under PBS conditions.

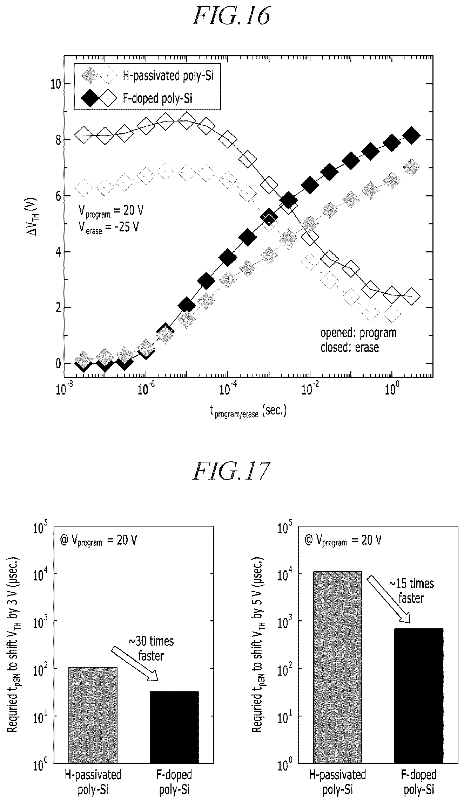

FIGS. 16 to 21 are graphs illustrating improvements in the memory characteristics of the three-dimensional memory device according to an embodiment of the present disclosure. The comparative example is a three-dimensional memory device in which trap sites are passivated with hydrogen through forming gas annealing.

Referring to FIG. 16, the program/erase speed characteristics are shown. The horizontal axis is defined as the program/erase time, and the vertical axis is defined as the threshold voltage. The unfilled pattern indicates the threshold voltage as a function of program time, and the filled pattern indicates the threshold voltage as a function of erase time. During the program operation, 20 V is applied to the gate, and -25 V is applied to the gate during the erase operation. Compared to the comparative example, the present disclosure exhibits a faster program speed at a given threshold voltage.

Referring to FIG. 17, the program time required to achieve a threshold voltage of 3 V is approximately 30 times shorter in the present disclosure compared to the comparative example. Similarly, the program time required to achieve a threshold voltage of 5 V is approximately 15 times shorter in the present disclosure compared to the comparative example. The results of FIGS. 16 and 17 demonstrate an improvement in memory operation speed.

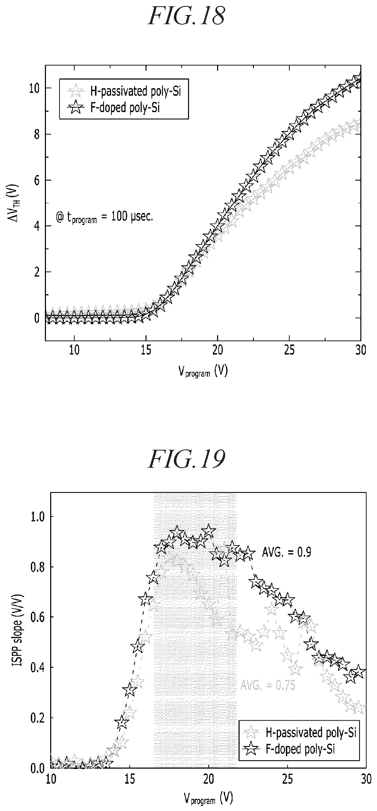

Referring to FIG. 18, the incremental step programming pulse (ISPP) characteristics are shown. The horizontal axis is defined as the program voltage, and the vertical axis is defined as the threshold voltage. The program time is specified as 100 µs. When comparing the slopes of the ISPP characteristics between the comparative example and the present disclosure, the ISPP characteristic of the present disclosure indicates improved performance, with the slope approaching 1.

Referring to FIG. 19, the specification of the ISPP slope is depicted. The graph illustrates the average value of the ISPP slope extracted near the operating voltage. When comparing the average slope values of the comparative example and the present disclosure, the fluorine-doped device exhibits a slope of 0.9 V/V, which is close to the theoretical upper limit of 1 V/V, whereas the comparative example shows a lower slope of 0.75 V/V. Additionally, the voltage at which the slope begins is lower in the present disclosure compared to the comparative example. The results of FIGS. 18 and 19 demonstrate improvements in ISPP characteristics. Together with the aforementioned PBS characteristic improvements, these findings indicate that the stability and reliability of the three-dimensional memory device can be enhanced.

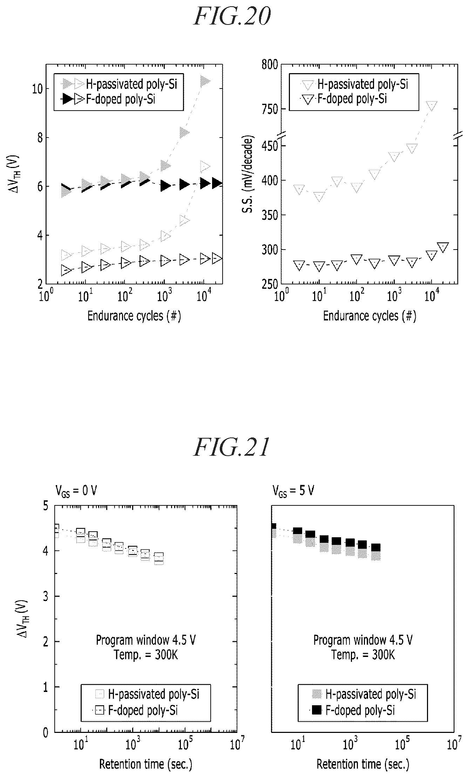

Referring to FIG. 20, the endurance characteristics are shown. As the number of program/erase cycles increases, the present disclosure maintains a consistent threshold voltage, whereas the comparative example exhibits a section in which the threshold voltage increases. The degradation of endurance characteristics in the comparative example is attributed to electron escape from the charge trapping layer CTL during the erase operation and interface degradation caused by electrons during hole injection. Accordingly, fluorine, which has a stronger bonding energy with silicon than hydrogen, is shown to provide superior endurance characteristics.

Referring to FIG. 21, the retention characteristics are shown. As the data retention time increases, both the present disclosure and the comparative example exhibit no significant degradation of data. This indicates that no adverse effects are observed from fluorine compared to hydrogen.

While certain exemplary embodiments have been described, it shall be appreciated by those skilled in the art that various modifications and alterations are possible without departing from the technical ideas and scope of the disclosure as set forth in the claims below. The embodiments disclosed herein are not intended to limit the technical ideas of the present disclosure, and all technical concepts and ideas falling within the scope of the claims and their equivalents are to be construed as being within the scope of the present disclosure.

## Claims

1. A three-dimensional memory device comprising:
a substrate;
a capping layer extending on the substrate in a vertical direction away from the substrate;
a fluorine-doped layer surrounding side surfaces of the capping layer, extending in the vertical direction, and including a fluorine-containing polymer;
a channel layer surrounding side surfaces of the fluorine-doped layer, extending in the vertical direction, and including polycrystalline silicon in which fluorine is diffused;
a memory layer surrounding side surfaces of the channel layer; and
a gate electrode layer surrounding side surfaces of the memory layer.

2. The three-dimensional memory device of claim 1, wherein the fluorine-containing polymer comprises at least one polymer selected from the group consisting of PFDA (3,3,4,4,5,5,6,6,7,7,8,8,9,9,10,10,10-heptadecafluorodecyl acrylate), PFDMA (3,3,4,4,5,5,6,6,7,7,8,8,9,9,10,10,10-heptadecafluorodecyl methacrylate), C6FA (3,3,4,4,5,5,6,6,7,7,8,8,8-tridecafluorooctyl acrylate), and C4FA (3,3,4,4,5,5,6,6,6-nonafluorohexyl acrylate).

3. The three-dimensional memory device of claim 1, wherein the fluorine-doped layer is in contact with an inner surface of the channel layer and covers the entire inner surface of the channel layer.

4. The three-dimensional memory device of claim **1,** wherein the capping layer comprises aluminum oxide.

5. The three-dimensional memory device of claim 1, wherein a doping concentration of fluorine in the channel layer is higher than a doping concentration of fluorine in the capping layer.

6. The three-dimensional memory device of claim 1, wherein an outer surface of the channel layer is in contact with the memory layer and comprises diffused fluorine.

7. The three-dimensional memory device of claim **1,** wherein the memory layer comprises:
a tunnel layer in contact with the channel layer and surrounding the side surfaces of the channel layer;
a charge trapping layer surrounding side surfaces of the tunnel layer; and
a blocking layer surrounding side surfaces of the charge trapping layer.

8. The three-dimensional memory device of claim 1, wherein the fluorine-doped layer is positioned opposite the gate electrode layer with the channel layer interposed therebetween.

9. A method of manufacturing a three-dimensional memory device, the method comprising:
forming a stacked structure on a substrate;
forming a channel hole penetrating the stacked structure in a vertical direction;
forming a memory layer on an inner surface of the stacked structure defined by the channel hole;
forming a channel layer on an inner surface of the memory layer;
forming a fluorine-doped layer comprising a fluorine-containing polymer on an inner surface of the channel layer;
forming a capping layer on an inner surface of the fluorine-doped layer; and
diffusing fluorine from the fluorine-doped layer into the channel layer through a thermal treatment process.

10. The method of claim 9, wherein the step of forming the fluorine-doped layer comprises:
injecting an initiator and a fluorine-containing monomer in a gaseous state onto the stacked structure;
heating the initiator to generate radicals;
adsorbing the monomer and the radicals onto a surface of the channel layer; and
forming a thin film comprising the fluorine-containing polymer based on polymerization by the radicals.

11. The method of claim 10, wherein the monomer comprises at least one selected from the group consisting of PFDA (3,3,4,4,5,5,6,6,7,7,8,8,9,9,10,10,10-heptadecafluorodecyl acrylate), PFDMA (3,3,4,4,5,5,6,6,7,7,8,8,9,9,10,10,10-heptadecafluorodecyl methacrylate), C6FA (3,3,4,4,5,5,6,6,7,7,8,8,8-tridecafluorooctyl acrylate), and C4FA (3,3,4,4,5,5,6,6,6-nonafluorohexyl acrylate), and wherein the fluorine-containing polymer comprises at least one selected from the group consisting of pPFDA (poly-PFDA), pPFDMA (poly-PFDMA), pC6FA (poly-C6FA), and pC4FA (poly-C4FA).

12. The method of claim 10, wherein the step of generating the radicals comprises decomposing the initiator into the radicals using a heating filament disposed and spaced apart on the stacked structure.

13. The method of claim 10, wherein a temperature of the substrate resulting from the heating in the step of generating the radicals is lower than a temperature of the substrate resulting from the thermal treatment in the step of diffusing fluorine.

14. The method of claim 9, further comprising, after the step of diffusing fluorine, removing the fluorine-doped layer and the capping layer.

15. The method of claim 14, further comprising filling a filler into a space from which the fluorine-doped layer and capping layer are removed.
